# EUROPEAN PATENT SPECIFICATION

(11) **EP 3 531 403 B1**
(45) Date of publication and mention of the grant of the patent: **28.09.2022**
(21) Application number: 17861745.2
(22) Date of filing: 17.10.2017
(51) Int. Cl.: G09F 9/00, G09F 9/30, G09F 9/33, G09F 9/40, H01L 33/48, H01L 25/075, H01L 25/16, H01L 27/32

(54) **ACTIVE MATRIX LED DISPLAY**
AKTIVMATRIX-LED-ANZEIGE
DISPOSITIF D'AFFICHAGE À DEL À MATRICE ACTIVE

(30) Priority: 19.10.2016 JP 2016205464
(43) Date of publication of application: 28.08.2019
(73) Proprietor: Organo-Circuit Incorporation, Kashiwa-shi, Chiba (JP)
(72) Inventor: YAMAGUCHI, Seiichiro, Osaka-shi Osaka 532-0004 (JP); TAKEYA, Junichi, Osaka-shi Osaka 532-0004 (JP); MATSUMURO, Tomonori, Osaka-shi Osaka 532-0004 (JP)
(74) Representative: Vossius & Partner Patentanwälte Rechtsanwälte mbB
(86) International application number: PCT/JP2017/038096
(87) International publication number: WO 2018/074611

(56) References cited:
- EP-A1- 3 503 186
- WO-A1-2013/008776
- JP-A- H10 111 517
- JP-A- 2004 006 724
- JP-A- 2005 101 269
- JP-A- 2007 183 605
- JP-A- 2008 033 095
- JP-A- 2010 079 196
- JP-A- 2012 238 001
- JP-A- 2015 180 924
- JP-A- 2015 198 145
- JP-A- 2016 033 635
- JP-U- 3 203 462
- US-A1- 2008 110 017
- US-A1- 2009 219 225
- US-A1- 2016 014 882
- US-A1- 2016 268 239

## Description

### [Technical Field]

The present invention relates to a large-area display. More particularly, it relates to a LED display capable of active matrix driving.

### [Background Art]

In recent years, a flat panel type display represented by a liquid crystal display has found widespread use, and has penetrated into various fields. The technological progress such as higher resolution or enlargement has also been intensified according to uses, resulting in advancements of the technological innovation in function in terms of flexibilization of a display. The liquid crystal method has become the current mainstream as the display method. Displays adopting organic EL also have been increasing in share mainly for small and medium size displays. Further, displays using LEDs also tend to increase as large-size displays mainly for outdoor uses.

As a new field of a flat panel display, the digital signage market using a display as an advertising medium substituting for paper at transportation facilities, retail stores, or the like has been expected to grow. Currently, advertisement or information spreading in trains, or POP advertising usage at retail stores by a small-size display has been the mainstream, but the latent need for digital signage is high for a large-size display. A study has been conducted on promotion of the consumption behavior by sending out video advertisements or sales promotional information according to the locations or the consumers' behavior situations, and further, event / service guides, or the like using a large-size display at large-scale commercial facilities, at venues, or in downtown. The high effectiveness of advertisement by a large-size display has also been observed by demonstration experiments or the like.

However, regardless of the high expectation of the market, the trend toward a larger-size display in digital signage has been progressing slowly. The reasons for this reside in that the actual display technology has cost and functional problems, and in that no large-size display technology present can find widespread use. As for the cost, it becomes an important element to suppress the installation cost due to enlargement in addition to the cost of the display main body. Further, most of the places in which large-size displays are set are inside and outside the existing structures. This requires a display technology capable of minimizing the amount of work on the existing structures, and of effectively using the space. In other words, there is a demand for a technology of a large-size display which is lightweight, bendable, and can be manufactured into an arbitrary shape at a low cost.

However, with the liquid crystal display technology which is the mainstream of the existing flat panel display, a display is manufactured on a large glass substrate. From this nature, the manufacturing cost rapidly increases with a trend toward a larger size. Furthermore, the manufacturable size has an upper limit. Signage or the like can be enlarged by combining a plurality of about 40 to 50inch liquid crystal displays. However, this case has not yet found widespread use because of the increased weight of the whole display, poor installability to the outside or the like, or other reasons.

Further, the organic EL technology is the most suitable for forming a lightweight and flexible display. A bendable display has already found widespread use, but still has many problems in mass production technology for enlargement. Further, use for signage requires a further improvement of characteristics for implementing the required luminance / life characteristic.

On the other hand, a display using LED is enlarged by a method of combining display units each including pixels integrated in a proper size, and hence does not have a size limit in principle. For this reason, a LED display is adopted for an ultra large-size display for use in the outside or the like. However, with the actual technology, it is not possible to form a display of an active matrix system capable of efficiently controlling the pixels. For this reason, it is necessary to perform complicated wiring on the substrate side on which LED elements are mounted, and to control the image of the display units by a complicated control circuit device. Accordingly, it is difficult to control the cost and the weight of the display, resulting in a hindrance to widespread use.

### [Citation List]

### [Patent Literature]

[PTL 1] Japanese Patent Application Publication No. 2005-84683
[PTL 2] Japanese Patent Application Publication No. 2002-141492

### [Non Patent Literature]

[NPL 1] Technology Development for Printed LSIs Based on Organic Semiconductors, 2014 Symposium on VLSI Circuits Digest of Technical Papers

US 2008/110017 A1 discloses an active matrix LED display formed on a substrate material having flexibility, the display comprising a pixel forming unit having at least one pixel driving circuit and at least one inorganic LED element electrically connected with the pixel driving circuit, wherein the pixel driving circuit is formed of at least one thin film transistor, the thin film transistor is an organic thin film transistor.

### [Summary of Invention]

### [Technical Problem]

In view of such circumstances, it is the main object of the present invention to provide a large-size, flexible and lightweight active matrix LED display capable of being easily set at various places at a low cost by reducing a large number of lead-out wires for driving LED elements, that enables the display unit to enlarge.

### [Solution to Problem]

The invention provides an active matrix LED display as defined in independent claim 1.

The pixel driving circuit substrate has at least one row selection line, at least one column selection line, at least one power supply line, and at least one ground line on the substrate, and has at least one inorganic LED element mounting terminal connected with the power supply line or the ground line at one side for each of the pixel forming units.

Each of the plurality of substrates includes a pattern for mounting the pixel driving circuit substrate and the inorganic LED element. The pixel driving circuit substrate substrate has flexibility.

The pixel driving circuit substrate of the active matrix LED display of the present invention preferably has at least four terminals of a row selection line connecting terminal, a column selection line connecting terminal, a power supply line connecting terminal, and an inorganic LED connecting terminal.

Each of the plurality of substrates has at least one row selection line, at least one column selection line, at least one power supply line, and at least one ground line on the substrate, and has at least one row selection line connecting terminal, at least one column selection line connecting terminal, at least one power supply line connecting terminal or ground line connecting terminal, and at least one inorganic LED element mounting terminal connected with the power supply line or the ground line at one side for each of the pixel forming units.

Preferably, each of the plurality of substrates have a junction mechanism for bonding or electrically joining the substrates at a substrate end.

For arranging a plurality of active matrix LED displays of the present invention in the column direction and in the row direction for enlargement, adjacent LED displays are bonded or electrically joined by a junction mechanism.

### [Advantageous Effects of Invention]

In accordance with the present invention, the wires set up on the entire display area surface of a display such as the row selection line, the column selection line, the power supply line, and the ground line required for active matrix display, display elements, and the pixel driving circuit can be formed by the most economically efficient processing methods and densities for themselves, respectively. For this reason, it becomes possible to restrict the enlargement of the manufacturing device in accordance with the enlargement of the display.

Specifically, as distinct from an organic LED (organic EL or OLED) element, for an inorganic LED element, the member formed by the existing solid semiconductor process, and subjected to a high-temperature heat treatment can be exclusively used for the inorganic LED element. For this reason, when this is mounted on a base material as a component, there is no process restriction. Accordingly, a flexible substrate of low-priced polyethylene terephthalate (PET) or the like can be used as a display substrate. As a result, it becomes possible to form various wires or insulation films set up on the entire display area surface on the display substrate by a low-priced roll to roll technology, printing technology, or the like. Further, it becomes possible to form pixel driving circuits at a high density on a flexible substrate with the most economically efficient size for the organic TFT process. This can minimize increases in the manufacturing costs along with the enlargement of the whole display. In addition, it is possible to implement a lightweight and flexible large-size active matrix LED display.

### [Brief Description of Drawings]

Fig. 1 is a view illustrating a display substrate 100 used in the present invention, and illustrating the manner of mounting LEDs 410, 411, and 412 of respective colors of RGB, and a pixel driving circuit substrate 300 including pixel driving circuits for driving respective LEDs formed thereon at a prescribed place of each pixel of the display substrate 100.
Fig. 2 is a view illustrating the state of the display substrate 100 immediately before mounting the LEDs and the pixel driving circuit substrate 300, including the top view showing a part of the top surface of the display substrate 100 on an enlarged scale, and the cross sectional view showing the part indicated with a broken line in the top view, where the alternate long short dash line in the top view represents the boundary between respective pixels.
Fig. 3 is a circuit diagram of a pixel driving circuit.
Fig. 4 is a view showing a cross sectional structure of an organic TFT.
Fig. 5 is a view showing a cross sectional structure of another organic TFT.
Fig. 6 is a view showing a cross sectional structure of a third substrate used in the present invention.
Fig. 7 is a cross sectional view of a third substrate including a pixel driving circuit substrate 300 and an inorganic LED element 400 mounted thereon used in the present invention.
Fig. 8 is a view illustrating an example of a junction method for bonding the third substrates, and implementing a large-size display of the present invention.

### [Description of Embodiments]

Below, embodiments of the present invention will be described in detail by reference to the accompanying drawings.

### Example 1

In the present example, a description will be given to an example in which a display with a size of 2.88 m × 1.62 m (pixel size 3 mm × 3 mm) in QHD standard is formed as for digital signage by a technology of manufacturing an active matrix type inorganic LED display including a pixel driving circuit using an organic TFT as each light emitting element provided therein with an inorganic LED element of each color of RGB as a light emitting element.

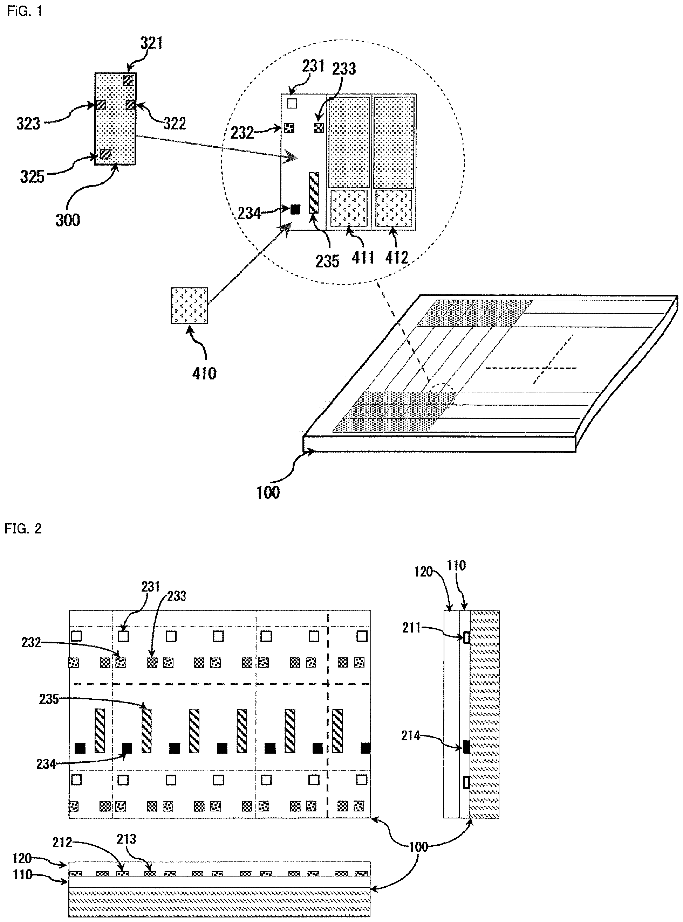

Fig. 1 shows a display substrate 100 used in the present invention, and shows the manner of mounting a pixel driving circuit substrate 300 for each of three colors in each pixel of the display substrate 100 of the display main body, and surface mounting inorganic LEDs 410, 411, and 412 of respective colors of RGB. On the display substrate 100, at the stage of mounting a pixel driving circuit substrate, and inorganic LEDs, a row selection line, a column selection line, a power supply line, and a ground line, and pads 231, 232, 233, and 234 electrically connected with the conductor lines, respectively are formed, and further, a wiring pattern 235 for connecting an output terminal 325 of the pixel driving circuit substrate and the anode of each LED is formed. On the pixel driving circuit substrate, terminals 321, 322, 323, and 325 to be connected with the internal circuit are provided, and are mounted by face down so as to be connected with the pads 231, 232, and 233, and the wiring pattern 235, respectively. Each LED is mounted so that the anode is connected with 235, and the cathode is connected with 234.

In the present example, all the conductor lines necessary for active matrix operation are formed before mounting the pixel driving circuit substrate and LEDs. However, the order of some formation steps thereof may vary with respect to the mounting step of the pixel driving circuit substrate or the LEDs.

Fig. 2 shows the state of the display substrate 100 before mounting the pixel driving circuit substrate 300 and the LEDs. On the substrate 100 of the display main body using a resin base material represented by PET (polyethylene terephthalate), PEN (polyethylene naphthalate), and PI (polyimide) as a material, using a printing technology represented by gravure offset printing or screen printing, the row selection line 211, the column selection line 212, the power supply line 213, and the ground line 214, and further the pads 231, 232, 233, and 234 for electrically connecting the conductor lines, and the LEDs, and the pixel driving circuit, and the wiring pattern 235 for connecting the LEDs and the output from the driving circuit are formed. Although not shown, the pads 231, 232, 233, and 234 are connected with the row selection line, the column selection line, the power supply line, and the ground line via VIA, respectively. The row selection line 211 is laid out so as to be in parallel with the long side of the display. The column selection line 212 and the power supply line 213 are laid out so as to be orthogonal to the row selection line 211 across the insulation film 110. The ground line 214 is laid out so as to be in parallel with the row selection line 211. The pads 231, 232, 233, and 234, and the wiring pattern 235 are formed on an insulation film 120.

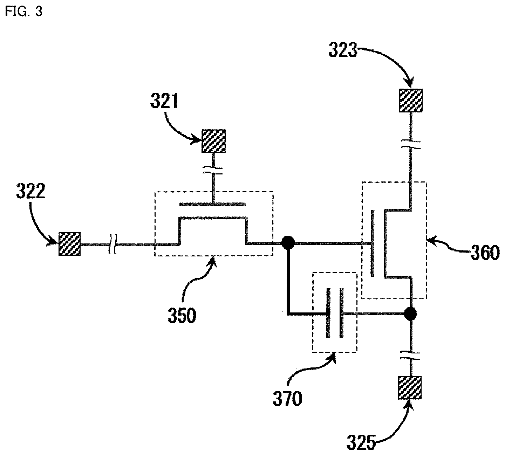

In the present example, as the pixel driving circuit, the circuit including a selection TFT and a driving TFT, and a holding capacitive element shown in Fig. 3 is mentioned as an example. However, another circuit system may be selected.

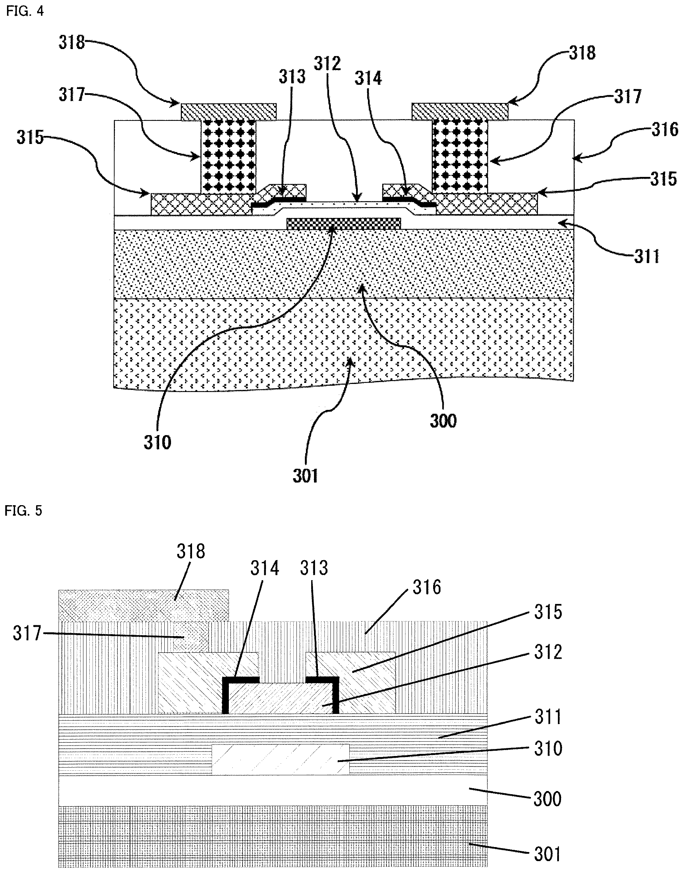

The pixel driving circuit can be formed by a high performance organic TFT circuit process of NPL 1, or the like. Fig. 4 shows the cross sectional part of an organic transistor in a pixel driving circuit substrate 300. The pixel driving circuit substrate 300 using a resin base material represented by PEN, PI, or the like as the substrate material is bonded onto a glass support substrate 301, thereby to perform an organic TFT circuit process treatment. The main steps include the formation of a gate electrode 310, formation of a gate insulation film 311, formation of an organic semiconductor single crystal film 312, formation of a metal film for a source electrode 313 and a drain electrode 314, patterning of the organic semiconductor single crystal film, the source electrode, and the drain electrode, formation of a wiring layer 315, formation of an insulation film layer 316, formation of VIA 317, and formation of a connecting terminal pad 318. The pixel driving circuit is formed by laying out a large number of pixel driving circuits at a high density on a substrate with a size most economically efficient as an organic TFT process. After the formation of the pixel driving circuit, the pixel driving circuit substrate 300 is released from the support substrate 301 on a per circuit basis, and is mounted on the display substrate 100.

Although not explicitly shown in Fig. 4, the holding capacitive element in the pixel driving circuit uses the gate insulation film 311 as a dielectric film, and a metal film for the gate electrode 310, the source electrode 313, and the drain electrode 314 as the electrode.

### Example 2

Then, a description will be given to a second example.

In accordance with the second example, as shown in the first example, on a first substrate, a pixel driving circuit including an organic semiconductor thin film is formed; an inorganic LED element is formed on a second substrate by an inorganic semiconductor process; wires and terminal pattern are formed on a third substrate by various printing methods, a photolithography method, or the like; and the first substrate and the second substrate are bonded together, and mounted onto a prescribed part on the third substrate; as a result, an active matrix LED display is manufactured. The difference from the first example resides in that mounting is achieved by face up in contrast to face down.

Then, second example will be described in detail.

First, the pixel driving circuit substrate 300 (Fig. 5) formed of a thin film transistor with a two-transistor 1-capacitor (2Tr-1C) shown in Fig. 3 is formed on the first substrate. However, in Fig. 5 and subsequent drawings, a description will be given by simple demonstration of one-transistor for simplification. However, actually, it is assumed that the element forming the circuit represented by Fig. 3 is included therein.

The first substrate is configured such that the resin-made substrate 300 having flexibility is formed on a handling provisional fixing substrate 301 during processing. At this step, as the handling provisional fixing substrate, the substrate has no particular restriction so long as the substrate is a rigid substrate having good dimensional stability represented by non-alkali glass, quartz glass, Si substrate, and the like.

Further, examples of the resin-made substrate having flexibility may include polyethylene terephthalate (PET), polyethylene naphthalate (PEN), polycarbonate (PC), polyimide (PI), polyether sulfone (PES), polyether imide (PEI), polyphenylene sulfide (PPS), fully aromatic polyamide (another name: aramid), polyphenylene ether (PPE), polyarylate (PAR), polybutylene terephthalate (PBT), polyoxymethylene (POM, another name: polyacetal), polyether ether ketone (PEEK), liquid crystal polymer (LCP) (e.g., molten liquid crystalline fully aromatic polyesters (basic skeleton: parahydroxybenzoic acid, biphenol, and phthalic acid), parylene, and a metal foil substrate.

Further, the film thickness of the resin-made substrate can be freely set at 1 µm to 500 µm according to the purpose, and is more preferably 1 µm to 150 µm, and most preferably 1 µm to 50 µm.

Then, a conductive thin film 310 is formed on the resin substrate. As the method for forming the conductive thin film 310, for example, mention may be made of the following method: the conductive thin film 310 is deposited on the resin-made substrate 300 by a PVD method represented by a sputtering method, and a vacuum deposition method, or by a coating method using an ink including a conductive film material; then, patterning is carried out into a prescribed shape by a photolithography method for formation.

As the materials for forming the conductive thin film 310, for example, mention may be made of a metal such as Au, Ag, Cu, Mo, W, Ti, Al, Pd, Pt, or Ta, alloys of the metals, and compounds of the metals. As the material for forming a conductive film, a material having high conductivity is preferable.

Alternatively, as another method for forming the conductive thin film 310, mention may be made of the following method: for example, by a form-based printing method or a formless printing method, the conductive thin film 310 patterned into a prescribed shape is formed directly on the resin-made substrate 510. By directly forming the conductive thin film 310 patterned into a prescribed shape, it is possible to simplify the step of forming the conductive thin film 310.

When the conductive thin film 310 patterned into a prescribed shape is directly formed by a form-based printing method or a formless printing method, an ink including various conductive film materials can be used. The ink including a conductive film material is preferably an ink including a material with a high conductivity. Examples thereof may include an ink including a conductive polymer compound such as PEDOT / PSS, a fine particle dispersed ink obtained by dispersing nanoparticle fine particles of an inorganic material, and a metal compound ink of copper salt, silver salt, or the like. Examples of the fine particles included in the fine particle dispersed ink may include nano-Au, nano-Ag, nano-Cu, nano-Pd, nano-Pt, nano-Ni, nano-ITO, nano-silver oxide, and nano-copper oxide. The fine particle dispersed ink including nano-silver oxide and nano-copper oxide may include a reducing agent.

Alternatively, the conductive thin film 310 may be formed by a plating method. As the methods for forming the conductive thin film 310 by a plating method, for example, mention may be made of the following method: by a photolithography method, a form-based printing method, or a formless printing method, a plating primer layer previously patterned into a prescribed shape is formed on the resin-made substrate 300, and the conductive thin film 310 is formed at a prescribed position by an electroless plating method, or a combination of an electroless plating method and an electrolytic plating method.

The film thickness of the conductive thin film 310 has no particular restriction, and is preferably 20 nm to 1 µm, and more preferably 20 nm to 300 nm. When the conductive thin film 310 is formed using a fine particle dispersed ink including nanoparticle fine particles of an inorganic material dispersed therein, the film thickness of the conductive thin film 310 is preferably 100 nm to 300 nm, and more preferably 150 nm to 250 nm. This is due to the following reason: the remains of the dispersant component or the like included in the fine particle dispersed ink or the particle growth of the nanoparticle fine particles in the baking treatment after deposition of the conductive thin film 310 results in ununiformity of the nanoparticle fine particles included in the conductive thin film 310; as a result, the conductivity may be inhibited; accordingly, with a film thickness of 100 nm or less, the conductivity may be reduced.

On the other hand, when the conductive thin film 310 is formed using silver salt or the like, the film thickness is preferably 20 nm to 100 nm, and more preferably 20 nm to 60 nm. This is due to the following reason: with silver salt or the like, a denser film is formed than with growth of nanoparticle fine particles, so that conductivity is expressed even with a smaller film thickness. The film can be made still thinner, resulting in a lower step difference of the gate electrode, which can also contribute to the improvement of the reliability of the insulation film thereon.

Then, a gate insulation film 311 is formed on the resin-made substrate 300 and the conductive thin film 310. The gate insulation film 311 is preferably an organic insulation film containing a ferroelectric having a high relative dielectric constant or a polymer compound. As the ferroelectric having a high relative dielectric constant, mention may be made of an inorganic metal compound represented by alumina (AlxOy), or hafnium oxide (HfxOy) . Examples of the polymer compound may include PS resin, PVP resin, PMMA resin, fluorine-containing resin, PI (polyimide) resin, PC (polycarbonate) resin, PVA (polyvinyl alcohol) resin, and parylene resin, and copolymers containing a plurality of repeating units contained in the resins. Out of these, the polymer compound is preferably a crosslinkable polymer compound because it is excellent in process resistance represented by solvent resistance, and stability.

The film thickness of the gate insulation film 311 has no particular restriction, and is preferably 1 nm to 1 µm, more preferably 20 nm to 100 nm, and further preferably 30 nm to 80 nm.

For the more preferable structure forming the gate insulation film 311, a lamination film of ferroelectric and an organic insulation film is more preferable, and the structures represented by alumina / PS resin, alumina / PVP resin, alumina / PMMA resin, alumina / fluorine-containing resin, alumina / polyimide resin, alumina / PVA resin, alumina / parylene resin, and the like are conceivable. The film thicknesses of respective structures are preferably 10 nm to 500 nm for the ferroelectric, and 10 nm to 500 nm for the organic insulation film, and more preferably 10 nm to 50 nm for the ferroelectric, and 10 nm to 100 nm for the organic insulation film, and further preferably 10 nm to 40 nm for the ferroelectric, and 10 nm to 40 nm for the organic insulation film.

Then, an organic semiconductor thin film 312 is formed on the gate insulation film 311. As the method for forming the organic semiconductor thin film 312, mention may be made of, for example, the following method: a material for forming the organic semiconductor thin film 312 is selectively deposited only in a prescribed region in which the organic semiconductor thin film 312 should be formed.

Specifically, via a mask represented by a metal mask or the like, a material for forming the organic semiconductor thin film 312 is deposited only in a prescribed region by a PVD method represented by a vacuum deposition method, thereby to form the organic semiconductor thin film 312.

Further, the following is also acceptable: a resin film having an opening is formed only in a prescribed region in which the organic semiconductor thin film 312 should be formed; subsequently, the organic semiconductor thin film 312 is formed entirely thereon by a vacuum deposition method. In this case, the opening of the resin film is preferably formed in an inverted tapered shape in which the opening area decreases with away from the substrate 1. This is due to the following reason: by using a resin film having an opening formed in an inverted tapered shape, the organic semiconductor thin film 312 formed in the opening and the organic semiconductor thin film 312 formed on the resin film are cut; accordingly, the resin film preferably functions as a separator.

Alternatively, as another method for forming the organic semiconductor thin film 312, for example, mention may be made of the following method: the organic semiconductor thin film 312 is deposited on the gate insulation film 311 by a PVD method represented by a vacuum deposition method, or a coating method using an ink including an organic semiconductor material; then, patterning is carried out into a prescribed shape by a photolithography method for formation.

Further, as a still other method for forming the organic semiconductor thin film 312, for example, mention may be made of the following method: by a form-based printing method or a formless printing method, the organic semiconductor thin film 312 patterned in a prescribed shape is directly formed on the gate insulation film 311. Direct formation of the organic semiconductor thin film 312 patterned in a prescribed shape can simplify the step of forming the organic semiconductor thin film 312.

However, in the present invention, a high current ability is required for driving inorganic LED elements. For this reason, out of these, most preferable is the following method: an organic single crystal film oriented in a uniaxial direction is deposited on the entire surface of the gate insulation film 311 by a coating method using a formless printing method, thereby to obtain the organic semiconductor thin film 312 patterned in a prescribed shape by a photolithography method.

When an organic single crystal film oriented in a uniaxial direction is deposited on the entire top surface of the gate insulation film 311 by a coating method using a formless printing method, and then, the organic semiconductor thin film 312 patterned in a prescribed shape by a photolithography method is formed, an ink including various organic semiconductor materials can be used, and an ink including a low molecular weight organic semiconductor material is preferably used. Further, after depositing the organic semiconductor thin film 312, a burning treatment may be carried out in order to control the morphology of the organic semiconductor thin film 312, or in order to volatilize the solvent included in the organic semiconductor thin film 312. The film thickness of the organic semiconductor thin film 312 has no particular restriction, and is preferably 1 nm to 1000 nm, more preferably 1 nm to 100 nm, and further preferably 1 nm to 50 nm. The best film is more preferably a crystal film with 3 to 5 molecular layers or less not depending upon the film thickness.

As the organic semiconductor materials, examples of a low molecular weight compound depositable by vapor deposition may include Pentacene, and copper phthalocyanine; and examples of a compound depositable by coating may include low molecular weight compounds or oligomer represented by pentacene precursors represented by 6,13-bis(triisopropylsilylethynyl)pentacene(Tips-Pentacene), 13,6-N-sulfinylacetamidopentacene (NSFAAP), 6,13-Dihydro-6,13-methanopentacene-15-one (DMP), Pentacene-N-sulfinyl-n-butylcarbamate adduct, Pentacene-N-sulfinyl-tert-butylcarbamate), and the like, and [1]Benzothieno[3,2-b]benzothiophene (BTBT), 3,11-didecyldinaphto[2,3-d:2',3'-d']benzo[1,2-b:4,5-b']dithiop hene (C10-DNBDT), those having a benzobisthiadiazole skeleton, porphyrine, benzoporphyrine, oligothiophene having an alkyl group or the like as a soluble group, and the like, or a polymer compound represented by polythiophene, fluorene copolymer, IDT-BT (indacenodithiophene benzothiadiazole) having a D-A structure, CDT-BT (Cyclopentadithiophene benzothiadiazole), and the like .

Then, a patterned conductive thin film 315 is formed on the gate insulation film 311 and the organic semiconductor thin film 312. The conductive thin film 315 forms the source electrode and the drain electrode of an organic thin film transistor.

The conductive thin film 315 can be formed by the same method as that for the conductive thin film 310. Incidentally, the formation of the conductive thin film 315 may be achieved by the same method as that for the formation of the conductive thin film 310, or may be formed by a different method.

The film thickness of the conductive thin film 315 (i.e., the film thickness of the source electrode and the drain electrode of the organic thin film transistor) has no particular restriction, and is preferably 20 nm to 1 µm, more preferably 20 nm to 600 nm, and further preferably 20 nm to 500 nm.

Then, a protective film 316 is formed on the gate insulation film 311, the organic semiconductor thin film 312, and the conductive thin film 315. As the method for forming the protective film 316, for example, mention may be made of the following method; the protective layer 316 is deposited by a PVD method represented by a vacuum deposition method, a CVD method represented by an ALD (atomic layer deposition) method, or a coating method using an ink including a protective layer material; then, patterning is carried out into a prescribed shape by a photolithography method. Alternatively, as another method for forming the protective layer 316, for example, mention may be made of a method of directly forming the protective film 316 patterned in a prescribed shape by a form-based printing method or a formless printing method. The direct formation of the protective layer 316 patterned in a prescribed shape can simplify the step of forming the protective layer 316.

Out of these, preferable is the method for directly forming the protective layer 316 patterned in a prescribed shape by a form-based printing method or a formless printing method.

When the protective layer 316 patterned in a prescribed shape is directly formed by a form-based printing method or a formless printing method, an ink including various protective layer materials can be used. Examples of the ink including the protective layer materials may include a dispersed ink including inorganic materials, an ink including SOG (spin on glass) materials, low molecular weight protective layer materials, and an ink including polymer protective layer materials. The ink including polymer protective layer materials is preferable.

Examples of the material for forming the protective layer 316 may include the same materials as those exemplified for the gate insulation film 311 other than the materials included in the foregoing inks, and the SOG materials.

The film thickness of the protective film 316 has no particular restriction, but is preferably 50 nm to 5 µm, and more preferably 500 nm to 3.0 µm.

Finally, an upper electrode 318 is formed on the protective layer 316 to complete a first substrate including the pixel driving circuit formed thereon. The method for forming the upper electrode 318 has no particular restriction, but may include a photolithography method, a form-based printing method, and a formless printing method. Out of these, a method using a screen (stencil printing plate) printing method which is one of the form-based printing methods is preferable.

Then, for an inorganic LED element 400 of the second substrate, a light emitting diode commercially available, or directly bought from a manufacturer as a component may only be mounted on the third substrate using a chip mounter. The most preferable inorganic LED element is a LED element of a bare chip. The dimensions thereof are preferably dimensions of 0.25 × 0.27 mm to 0.4 × 0.2 mm (so-called, 0201 to 0402). Alternatively, an inorganic LED element with dimensions of 1.6 × 0.8 mm (1608) for monocolor light emission, or 1.6 × 1.5mm (1615) per chip including three colors merged therein, for full-color one is also acceptable. The most preferable form is a full-color type bare chip inorganic LED element.

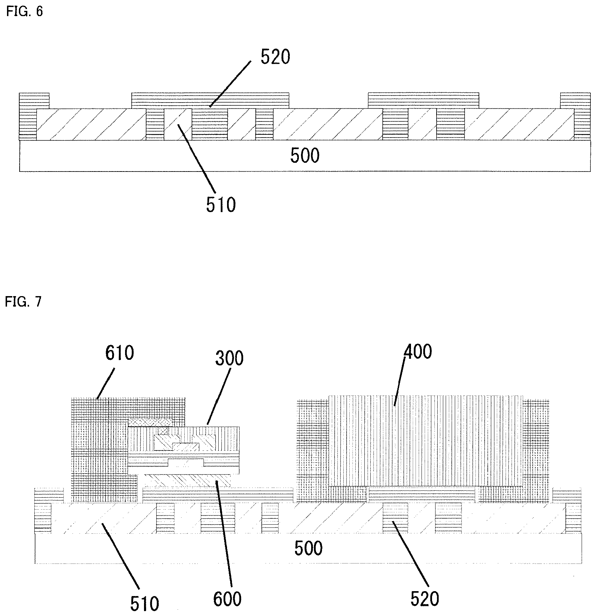

Then, a third substrate (Fig. 6) is manufactured. The third substrate may be fixed to a carrier substrate as with the first substrate, and the process may be carried out by roll to roll. The optimum method at that step can be used.

First, an electrode pattern 510 is formed on the third substrate. As the method for pattern forming the electrode pattern 510, a screen printing method is the most preferable, but a photolithography method is also acceptable. Then, the process appropriately goes through a burning step and the like to obtain the electrode pattern 510.

Then, an insulation film pattern 520 having openings at the terminal part of the substrate end, and the positions at which the pixel driving circuit substrate 300, and the inorganic LED element 400 are mounted is pattern formed thereon. As the method for pattern forming the insulation film pattern 520, a screen printing method is the most preferable, but a photolithography method after slit or spin coating is also acceptable. This process also appropriately goes through a burning step and the like to obtain the insulation film pattern 520. The process goes through this step, thereby to complete the third substrate.

Then, on the third substrate, the pixel driving circuit substrate 300 and the inorganic LED element 400 are mounted on the third substrate (Fig. 7) . As the mounting method, mounting may be carried out using a general chip mounting device. As for the method for fixing the pixel driving circuit substrate 300 and the inorganic LED element 400 on the third substrate, an adhesive 600 may be previously pattern formed at the mounting position by a screen printing method, or the like. Further, the following is also acceptable: before and after mounting, Ag paste 610 before sintering is coated at the place in which the pixel driving circuit substrate 300 and the inorganic LED element 400 are mounted by screen printing, and after mounting, sintering is achieved, thereby to fix the mounting components.

With the best mounting method, an adhesive 600 is previously coated at the mounting place of the pixel driving circuit substrate 300; thereon, the pixel driving circuit substrate 300 is mounted and fixed by face up; then, the Ag paste 610 is printed by screen printing so as to extend across the terminal part of the pixel driving circuit substrate 300 and the connecting terminal provided on the third substrate for establishing connection with the pixel driving circuit substrate 300. Further, in the same step, the Ag paste 610 is also pattern formed at the connecting terminal portion for mounting the inorganic LED element 400. Then, the inorganic LED element 400 is mounted with the light emitting surface oriented in the face up direction. Finally, the Ag paste 610 is dried at 100°C for 30 minutes. As a result, mounting of the components onto the third substrate is completed.

Basically, the dimensions of the third substrate may be set according to the work size of the print circuit substrate. Then it is not necessary to adopt special specifications for introducing a manufacturing device such as a screen printing machine. For example, for the copper-clad lamination sheet, the maximum size is determined as 1000 (1020) × 1000 (1020) mm or 1000 (1020) × 1200 (1220) mm. This can be divided into four parts each with a work size of 500 (510) × 500 (510) mm, or a smaller work size for use.

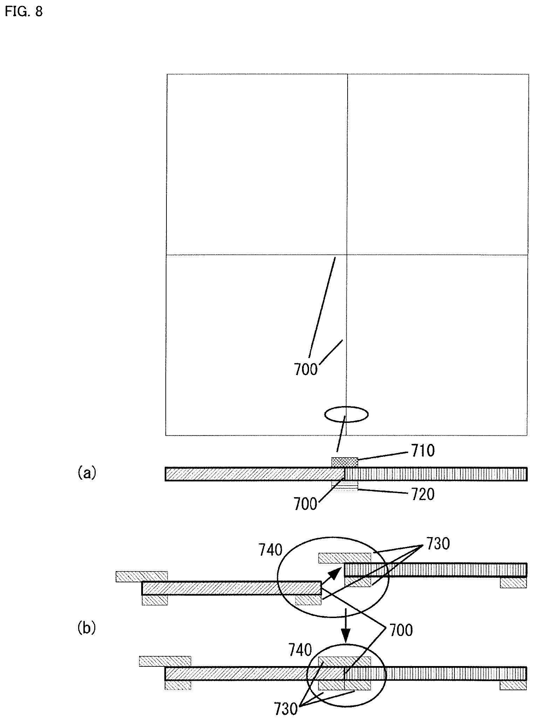

Then, a description will be given to the case where the third substrates are bonded together to manufacture a large-size display. A plurality of 500 × 500 mm substrates are bonded together in the column direction and the row direction. As a result, a large-size active matrix LED display can be implemented. Preferably, the junction surface 700 for connecting the third substrates at this step is bonded using an adhesive 710 having conductivity at least for the electrode terminal part; and other substrate portions are connected by a resin-made adhesive 720 (Fig. 8(a)). Alternatively, most preferably, a junction mechanism 740 using a magnet 730, or the like is provided at each panel end, and a connection between respective substrates is established at one touch (Fig. 8(b)).

### [Industrial Applicability]

The present example has shown the following: a pixel driving circuit using a high performance organic TFT capable of driving LED and the inorganic LED element are manufactured independently on different substrates from a display substrate; the resulting ones are mounted on the display substrate; as a result, it is possible to implement an active matrix system LED display. However, the following is also acceptable: a pixel driving circuit by an organic TFT is formed directly on a display substrate, and an inorganic LED element is mounted thereon. In accordance with the present invention, the circuits and wires necessary for controlling inorganic LED pixels are minimized, which can reduce the weight of the whole display. This can achieve the reduction of the installation cost and the ultraflexibility of a large-size LED display substrate.

### [Reference Signs List]

- 100: Active matrix LED display substrate
- 110, 120: Insulation film on display substrate 100
- 211: Row selection line
- 212: Column selection line
- 213: Power supply line
- 214: Ground line
- 231: Pad for establishing connection with row selection line
- 232: Pad for establishing connection with column selection line
- 233: Pad for establishing connection with power source line
- 234: Pad for establishing connection with ground line
- 235: Wiring pattern for establishing connection between output from pixel driving circuit and anode of LED
- 300: Substrate for forming pixel driving circuit
- 301: Support substrate for use in pixel driving circuit formation step
- 310: Gate electrode of organic TFT
- 311: Gate insulation film of organic TFT
- 312: Single crystal organic semiconductor film of organic TFT
- 313: Source electrode of organic TFT
- 314: Drain electrode of organic TFT
- 315: Circuit wiring of organic TFT
- 316: Insulation film on organic TFT
- 317: VIA for establishing connection between wiring layers
- 318: Pad on VIA
- 321: Terminal connected to row selection line with electrode pad of pixel driving circuit substrate
- 322: Terminal connected to column selection line with electrode pad of pixel driving circuit substrate
- 323: Terminal connected to power supply line with electrode pad of pixel driving circuit substrate
- 325: Terminal connected to anode of LED with electrode pad of pixel driving circuit substrate
- 350: Selection TFT in pixel driving circuit
- 360: Driving TFT in pixel driving circuit
- 370: Holding capacitive element in pixel driving circuit
- 500: Third substrate
- 510: Electrode pattern on third substrate
- 520: Insulation film pattern on third substrate
- 600: Adhesive for mounting driving circuit substrate
- 610: Ag paste
- 700: Junction surface between substrates
- 710: Adhesive having conductivity for bonding substrates
- 720: Adhesive made of resin for bonding substrates
- 730: Magnet
- 740: Junction mechanism

## Claims

1. An active matrix LED display comprising a plurality of display substrates (100, 500) each having flexibility, a plurality of pixel forming units formed on each of the substrates, each of the pixel forming units having a plurality of pixels, each of the pixels having a pixel driving circuit substrate (300) and an inorganic LED element (410, 411, 412), the pixel driving circuit substrate including a pixel driving circuit formed thereon and the inorganic LED element being electrically connected with the pixel driving circuit such that each inorganic LED element has an individual driving circuit, wherein the pixel driving circuit is formed of at least one organic thin film transistor, wherein the plurality of substrates are arranged in the column direction and the row direction, and wherein each of the plurality of substrates has an inter-substrate connecting terminal at a substrate end for electrically connecting the pixel driving circuits to one another.

2. The active matrix LED display according to claim 1, wherein the inorganic LED element (410, 411, 412) is mounted as a component on the pixel driving circuit substrate (300).

3. The active matrix LED display according to claim 2, wherein the pixel driving circuit substrate (300) has at least one row selection line (211), at least one column selection line (212), at least one power supply line (213), and at least one ground line (214) on the substrate, and has at least one inorganic LED element mounting terminal connected with the power supply line (213) or the ground line (214) at one side for each of the pixel forming units.

4. The active matrix LED display according to claim 1, wherein each of the plurality of display substrates (500) includes a pattern for mounting the pixel driving circuit substrate (300) and the inorganic LED element (410, 411, 412), and wherein the pixel driving circuit substrate (300) has flexibility.

5. The active matrix LED display according to claim 4, wherein the pixel driving circuit substrate (300) has at least four terminals of a row selection line connecting terminal (321), a column selection line connecting terminal (322), a power supply line connecting terminal (323), and an inorganic LED connecting terminal (325).

6. The active matrix LED display according to claim 4, wherein each of the plurality of display substrates (500) has at least one row selection line (211), at least one column selection line (212), at least one power supply line (213), and at least one ground line (214) on the substrate, and has at least one row selection line connecting terminal (231), at least one column selection line connecting terminal (232), at least one power supply line connecting terminal (233) or ground line connecting terminal (234), and at least one inorganic LED element mounting terminal connected with the power supply line or the ground line at one side for each of the pixel forming units.

7. The active matrix LED display according to claim 4, wherein each of the plurality of display substrates (500) have a junction mechanism (740) for bonding or electrically joining the substrates at a substrate end.

## Patentansprüche

1. Aktivmatrix-LED-Anzeige, die aufweist: mehrere Anzeigesubstrate (100, 500), die jeweils eine Flexibilität aufweisen, mehrere Pixelbildungseinheiten, die auf jedem der Substrate ausgebildet sind, wobei jede der Pixelbildungseinheiten mehrere Pixel aufweist, wobei jedes der Pixel ein Pixeltreiber-Schaltungssubstrat (300) und ein anorganisches LED-Element (410, 411, 412) aufweist, wobei das Pixeltreiber-Schaltungssubstrat eine darauf ausgebildete Pixeltreiberschaltung aufweist und das anorganische LED-Element elektrisch mit der Pixeltreiberschaltung verbunden ist, so dass jedes anorganische LED-Element eine individuelle Treiberschaltung aufweist, wobei die Pixeltreiberschaltung aus mindestens einem organischen Dünnschichttransistor gebildet ist, wobei die mehreren Substrate in der Spaltenrichtung und der Zeilenrichtung angeordnet sind, und wobei jedes der mehreren Substrate einen Zwischensubstrat-Verbindungsanschluss an einem Substratende zum elektrischen Verbinden der Pixeltreiberschaltungen miteinander aufweist.

2. Aktivmatrix-LED-Anzeige nach Anspruch 1, wobei das anorganische LED-Element (410, 411, 412) als eine Komponente auf dem Pixeltreiber-Schaltungssubstrat (300) montiert ist.

3. Aktivmatrix-LED-Anzeige nach Anspruch 2, wobei das Pixeltreiber-Schaltungssubstrat (300) mindestens eine Zeilenauswahlleitung (211), mindestens eine Spaltenauswahlleitung (212), mindestens eine Stromversorgungsleitung (213) und mindestens eine Masseleitung (214) auf dem Substrat und mindestens einen Befestigungsanschluss für das anorganische LED-Element aufweist, der mit der Stromversorgungsleitung (213) oder der Masseleitung (214) an einer Seite für jede der Pixelbildungseinheiten verbunden ist.

4. Aktivmatrix-LED-Anzeige nach Anspruch 1, wobei jedes der mehreren Anzeigesubstrate (500) ein Muster zum Anbringen des Pixeltreiber-Schaltungssubstrats (300) und des anorganischen LED-Elements (410, 411, 412) enthält, und wobei das Pixeltreiber-Schaltungssubstrat (300) eine Flexibilität aufweist.

5. Aktivmatrix-LED-Anzeige nach Anspruch 4, wobei das Pixeltreiber-Schaltungssubstrat (300) mindestens vier Anschlüsse aufweist, nämlich einen Zeilenauswahlleitungs-Verbindungsanschluss (321), einen Spaltenauswahlleitungs-Verbindungsanschluss (322) und eine Stromversorgungsleitungs-Verbindungsanschluss (323) und einen Verbindungsanschluss (325) für eine anorganische LED.

6. Aktivmatrix-LED-Anzeige nach Anspruch 4, wobei jedes der mehreren Anzeigesubstrate (500) mindestens eine Zeilenauswahlleitung (211), mindestens eine Spaltenauswahlleitung (212), mindestens eine Stromversorgungsleitung (213) und mindestens eine Masseleitung (214) auf dem Substrat aufweist und mindestens einen Zeilenauswahlleitungs-Verbindungsanschluss (231), mindestens einen Spaltenauswahlleitungs-Verbindungsanschluss (232), mindestens einen Stromversorgungsleitungs-Verbindungsanschluss (233) oder einen Masseleitungs-Verbindungsanschluss (234) und mindestens einen Montageverbindungsanschluss für ein anorganisches LED-Element aufweist, der mit der Stromversorgungsleitung oder der Masseleitung an einer Seite für jede der Pixelbildungseinheiten verbunden ist.

7. Aktivmatrix-LED-Anzeige nach Anspruch 4, wobei jedes der mehreren Anzeigesubstrate (500) einen Verbindungsmechanismus (740) zum Bonden oder elektrischen Verbinden der Substrate an einem Substratende aufweist.

## Revendications

1. Afficheur LED à matrice active, comprenant une pluralité de substrats d'afficheur (100, 500) présentant chacun une flexibilité, une pluralité d'unités formatrices de pixels formées sur chacun des substrats, chacune des unités formatrices de pixels ayant une pluralité de pixels, chacun des pixels ayant un substrat de circuit de commande de pixels (300) et un élément LED inorganique (410, 411, 412), le substrat de circuit de commande de pixels comprenant un circuit de commande de pixels formé sur celui-ci et l'élément LED inorganique étant connecté électriquement au circuit de commande de pixels, de telle manière que chaque élément LED inorganique comporte un circuit de commande individuel, le circuit de commande de pixels étant formé d'au moins un transistor à film mince inorganique, la pluralité de substrats étant agencée dans le sens des colonnes et dans le sens des rangées, et chaque substrat de la pluralité de substrats présentant une borne de connexion inter-substrats à une extrémité de substrat pour la connexion électrique des circuits de commande de pixels entre eux.

2. Afficheur LED à matrice active selon la revendication 1, où l'élément LED inorganique (410, 411, 412) est monté comme composant sur le substrat de circuit de commande de pixels (300).

3. Afficheur LED à matrice active selon la revendication 2, où le substrat de circuit de commande de pixels (300) a au moins une ligne de sélection de rangée (211), au moins une ligne de sélection de colonne (212), au moins une ligne d'alimentation en courant (213), et au moins une ligne de terre (214) sur le substrat, et a au moins une borne de montage d'élément LED inorganique connectée à la ligne d'alimentation en courant (213) ou à la ligne de terre (214) sur un côté pour chacune des unités formatrices de pixels.

4. Afficheur LED à matrice active selon la revendication 1, où chaque substrat de la pluralité de substrats d'afficheur (500) comporte un motif pour le montage du substrat de circuit de commande de pixels (300) et de l'élément LED inorganique (410, 411, 412), et où le substrat de circuit de commande de pixels (300) présente une flexibilité.

5. Afficheur LED à matrice active selon la revendication 4, où le substrat de circuit de commande de pixels (300) comporte au moins quatre bornes entre une borne de connexion de ligne de sélection de rangée (321), une borne de connexion de ligne de sélection de colonne (322), une borne de connexion de ligne d'alimentation en courant (323) et une borne de connexion de LED inorganique (325).

6. Afficheur LED à matrice active selon la revendication 4, où chaque substrat de la pluralité de substrats d'afficheur (500) comporte au moins une ligne de sélection de rangée (211), au moins une ligne de sélection de colonne (212), au moins une ligne d'alimentation en courant (213) et au moins une ligne de terre (214) sur le substrat, et comporte au moins une borne de connexion de ligne de sélection de rangée (231), au moins une borne de connexion de ligne de sélection de colonne (232), au moins une borne de connexion de ligne d'alimentation en courant (233) ou une borne de connexion de ligne de terre (234), et au moins une borne de montage d'élément LED inorganique connectée à la ligne d'alimentation en courant ou à la ligne de terre sur un côté pour chacune des unités formatrices de pixels.

7. Afficheur LED à matrice active selon la revendication 4, où chaque substrat de la pluralité de substrats d'afficheur (500) présente un mécanisme de jonction (740) pour la liaison ou la jonction électrique des substrats à une extrémité de substrat.
